# FASCICULE DE BREVET EUROPEEN

(11) **EP 1 027 583 B1**
(45) Date de publication et mention de la délivrance du brevet: **11.03.2009**
(21) Numéro de dépôt: 98951553.1
(22) Date de dépôt: 26.10.1998
(51) Int. Cl.: G01L 9/00, G01P 15/08

(54) **STRUCTURE MUNIE DE CONTACTS ELECTRIQUES FORMES A TRAVERS LE SUBSTRAT DE CETTE STRUCTURE ET PROCEDE D'OBTENTION D'UNE TELLE STRUCTURE**
STRUKTUR MIT DURCH DIESE STRUKTUR LAUFENDEN , HERGESTELLTEN ELEKTRISCHEN KONTAKTEN, UND VERFAHREN ZUR DEREN HERSTELLUNG
STRUCTURE EQUIPPED WITH ELECTRIC CONTACTS FORMED THROUGH SAID STRUCTURE SUBSTRATE AND METHOD FOR OBTAINING SAID STRUCTURE

(30) Priorité: 27.10.1997 FR 9713441
(43) Date de publication de la demande: 16.08.2000
(73) Titulaire: COMMISSARIAT A L'ENERGIE ATOMIQUE, 75015 Paris (FR)
(72) Inventeur: CAPLET, Stéphane, F-38360 Sassenage (FR); DELAYE, Marie-Thérèse, F-38100 Grenoble (FR)
(74) Mandataire: Poulin, Gérard
(86) Numéro de dépôt international: PCT/FR1998/002286
(87) Numéro de publication internationale: WO 1999/022212

(56) Documents cités:
- US-A- 4 208 782
- US-A- 4 463 336
- US-A- 4 773 972
- US-A- 5 323 656
- US-A- 5 511 428
- US-A- 5 591 679
- US-A- 5 683 919
- MASAYOSHI ESASHI ET AL: "ABSOLUTE PRESSURE SENSORS BY AIR-TIGHT ELECTRICAL FEEDTHROUGH STRUCTURE" SENSORS AND ACTUATORS A, vol. A23, no. 1 / 03, 1 avril 1990, pages 1048-1052, XP000355782 cité dans la demande

## Description

### DOMAINE TECHNIQUE

La présente invention concerne une structure formée sur un substrat et munie d'un contact électrique ou d'une pluralité de contacts électriques ainsi qu'un procédé d'obtention d'une telle structure.

L'invention s'applique notamment à tout type de structure (par exemple un accéléromètre, un capteur de pression ou un actionneur) que l'on forme à la surface d'une couche appropriée.

Cette couche peut être électriquement conductrice (par exemple en silicium ou en polysilicium) et formée sur un isolant électrique.

### ÉTAT DE LA TECHNIQUE ANTÉRIEURE

On connaît déjà des micro-systèmes électromécaniques formés sur des puces (« chips ») par des techniques de fabrication en surface.

Pour connecter électriquement au monde extérieur une puce sur laquelle est formée un tel micro-système on forme à la surface de cette puce des plots métalliques de contact qui constituent une interface entre les zones électriquement actives de la puce et le monde extérieur, ce dernier étant par exemple constitué par un dispositif électronique de mesure.

Le micro-système a parfois besoin d'être maintenu dans un milieu confiné pour des questions d'herméticité.

Dans ce cas, il est connu de munir la puce d'un capot qui enferme le micro-système.

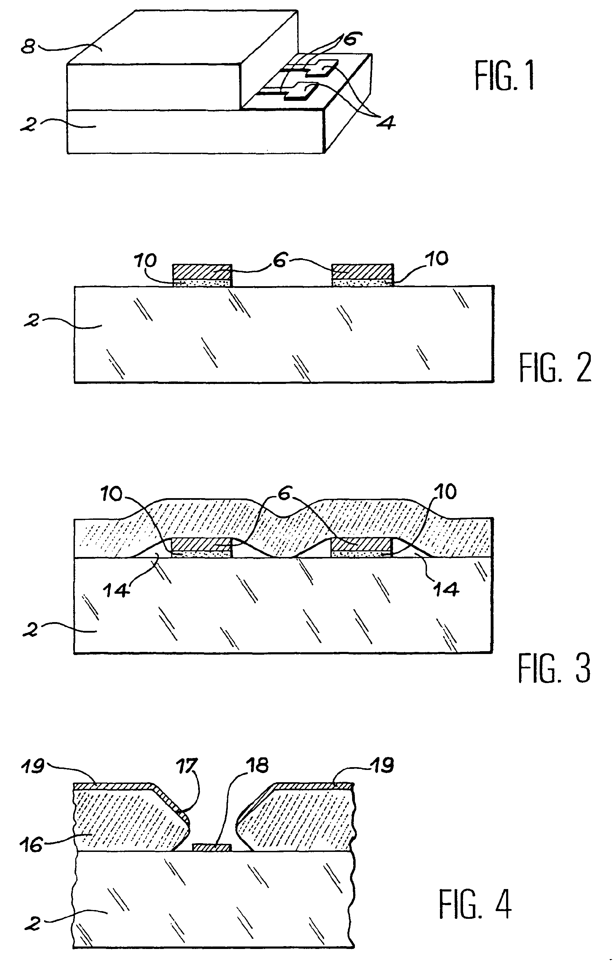

Ceci est schématiquement illustré par la figure 1.

On voit sur celle-ci la puce 2 ainsi que les plots de contact 4 qui sont reliés par des lignes de contact 6 aux zones électriquement actives (non représentées) de la puce.

On voit également le capot 8 qui recouvre le micro-système (non représenté) mais pas les plots de contact qui, de façon classique, sont accessibles sur un côté de la puce.

Un tel capot complique la formation des contacts électriques avec le micro-système.

La formation des lignes de contact 6 qui aboutissent aux plots de contact 4, avec un passage électrique de la zone recouverte par le capot 8 vers l'extérieur de celui-ci et plus précisément vers la zone où les plots de contact apparaissent, affecte la planéité de la zone que l'on veut sceller.

Pour former chaque ligne de contact 6, on est amené à former un dépôt métallique de quelques centaines de nanomètres d'épaisseur.

De tels dépôts créent des marches qui peuvent constituer un obstacle pour le scellement surtout si l'on veut que ce scellement soit hermétique.

Ceci est schématiquement illustré par la figure 2 qui est une vue en coupe transversale schématique de la figure 1 au niveau des lignes de contact 6.

On voit également sur cette figure 2 des couches électriquement isolantes 10 qui sont interposées entre les lignes de contact 6 et la puce 2 proprement dite.

A titre d'exemple, un scellement de type « Silicon Direct Bonding » nécessite une parfaite planéité de la puce et du capot.

Les marches sont donc rédhibitoires pour ce type de scellement.

Si l'on considère l'exemple du scellement anodique, celui-ci n'exige pas une parfaite planéité.

Par contre l'herméticité ne peut être garantie avec un tel scellement.

Ceci est schématiquement illustré par la figure 3.

On voit sur cette figure 3 qu'un substrat en verre et une puce en silicium 2 peuvent être scellés l'un à l'autre de part et d'autre des marches mais qu'il reste des zones mal scellées 14 qui font office d'évents.

Ceci compromet donc l'herméticité du scellement anodique.

Une autre technique connue consiste à effectuer une métallisation à travers un trou dans un capot de verre scellé anodiquement de façon qu'aucune ligne de contact ne traverse le scellement.

A ce sujet on consultera le document suivant :
M. Esashi, Y. Matsumoto et S. Shoji, « Absolute Pressure Sensors by Air-tight Electrical Feedthrough Structure », Sensors and Actuators, A21-A23 (1990) 1048-1052.

Ceci est schématiquement illustré par la figure 4 où l'on voit la puce 2 qui est scellée au capot de verre 16. Ce capot de verre est traversé par un trou 17 et l'on voit sur la figure 4 la couche métallique 18 résultant de la métallisation de la puce à travers ce trou. On voit aussi des couches métalliques 19 qui ont été formées sur le capot au moment de la formation de la couche 18. La structure active (un accéléromètre, un capteur de pression ou un actionneur) et le capot de verre sont formés chacun de leur côté avant d'être scellés l'un à l'autre. Cette autre technique connue peut être éventuellement transposée au scellement d'une puce et d'un capot en silicium. Cela pose cependant le problème de la compatibilité de traitement entre la mise en forme du trou, le type de scellement, la préparation de surface avant la métallisation et le recuit de cette métallisation.

Mais le principal inconvénient de cette technique connue réside dans le fait que l'on traite différents substrats que l'on assemble ensuite l'un à l'autre. De plus, cette technique impose l'utilisation d'un capot de verre et un procédé d'élaboration de ce capot plutôt complexe.

WO 95/34912 décrit un capteur de force et un procédé de fabrication. US 5277067 décrit un capteur de pression miniature et des réseaux de tels capteurs. US 5055077 décrit un dispositif d'émission de champ à cathode froide.

### EXPOSÉ DE L'INVENTION

La présente invention a pour but de remédier aux inconvénients précédents.

L'invention propose de réaliser une structure et chaque contact électrique de celle-ci dans un empilement de couches, empilement qui a donc été formé avant la fabrication de la structure.

Cet empilement peut être un empilement classique monolithique, voire un empilement standard par exemple du type SIMOX.

La structure munie de ses contacts électriques est obtenue dans cet empilement.

Le capotage de cette structure, s'il est nécessaire, peut être obtenu par diverses techniques comme par exemple
- un scellement au moyen d'un polymère,
- un scellement anodique ou
- un scellement par la technique appelée « Silicon Direct Bonding ».

Selon l'invention, chaque contact électrique est formé sur la face-arrière de la couche dans laquelle on forme la structure, à travers un trou formé dans le substrat sur lequel se trouve cette couche.

Cette façon de faire va à l'encontre de l'état de la technique mentionné plus haut dans lequel on envisage seulement de former des contacts électriques sur la face-avant de la couche.

Plus précisément, l'invention résout les problèmes suivants : (a) obtenir une structure comportant une couche formée sur un substrat et munie d'un contact électrique formé en regard de ce substrat et électriquement isolé de celui-ci (ce qui permet notamment de minimiser la capacité parasite qui existe entre le contact et le substrat) et (b) être capable de former le contact au cours de la toute dernière étape de fabrication de la structure et, plus précisément, déterminer une architecture permettant de délimiter le ou les contacts de façon à ce qu'ils soient réalisables par simple dépot conducteur, sans étape de gravure supplémentaire.

De façon précise, la présente invention a tout d'abord pour objet un dispositif conformément à la revendication 1.

Selon un mode de réalisation particulier de l'invention, la première couche est électriquement conductrice, le substrat comprend une deuxième couche qui est électriquement isolante et la première couche repose sur cette deuxième couche.

La présente invention a également pour objet un procédé de fabrication du dispositif conformément à la revendication 3.

Selon un mode de mise en oeuvre préféré du procédé objet de l'invention, on forme une couche sacrificielle sur le substrat puis la première couche sur cette couche sacrificielle, on grave cette couche sacrificielle à travers le trou de façon que le bord du trou le plus proche de la première couche forme un surplomb par rapport à celle-ci et on forme le contact électrique sur la face-arrière de la première couche à travers le trou.

De préférence, le contact électrique est formé par dépôt de métal sur la face-arrière de la première couche à travers le trou.

Selon un mode de mise en oeuvre particulier du procédé objet de l'invention, la première couche est électriquement conductrice, le substrat comprend une deuxième couche qui est électriquement isolante et l'on forme la couche sacrificielle sur cette deuxième couche puis la première couche sur cette couche sacrificielle.

Selon un deuxième mode de mise en oeuvre particulier, la première couche est électriquement conductrice, le substrat comprend une deuxième couche qui est électriquement isolante et l'on forme la première couche sur cette deuxième couche, cette deuxième couche constituant la couche sacrificielle.

La couche sacrificielle peut servir de couche d'arrêt lors de la formation de chaque trou.

Selon un mode de mise en oeuvre particulier de l'invention, on forme le trou par une gravure permettant aussi la formation d'une cavité et d'un surplomb dans le substrat du côté de la face-arrière de la couche sacrificielle, et on grave ensuite la couche sacrificielle jusqu'à la première couche.

Chaque trou peut être formé avant de former la structure dans la première couche (ou après avoir formé cette structure) si le procédé le permet.

Selon un mode de mise en oeuvre particulier du procédé objet de l'invention, après avoir formé le microsystème dans la première couche, on forme, sur la face-avant de la première couche, un capot destiné à confirmer le microsystème.

Chaque contact électrique peut être formé avant la formation de la structure dans la première couche mais, si on le souhaite, on y peut former chaque contact électrique après avoir formé le microsystème dans la première couche.

Lorsqu'on forme un capot destiné à confiner la structure, on peut même former chaque contact électrique après avoir formé ce capot.

La présente invention présente divers avantages.

Lors de la mise en oeuvre de l'invention, la face-avant de la première couche reste plane, .sans ligne de contact métallique qui provoque des marches.

Ceci permet d'envisager des scellements aussi divers que le scellement par la technique appelée « Silicon Direct Bonding » ou le scellement anodique.

La possibilité d'un scellement anodique est très intéressante pour l'encapsulation hermétique sous vide.

L'invention est aussi très bien adaptée à l'utilisation d'un substrat SOI commercialement disponible, comme par exemple un substrat de type SIMOX ou un empilement Si-SiO₂-Si obtenu par une technique du type « Silicon Direct Bonding ».

De plus le fait que la formation des contacts (c'est-à-dire la métallisation) puisse être reportée après capotage permet de mettre en oeuvre des procédés à haute température comme par exemple le recuit de scellement lorsqu'on utilise la technique appelée « Silicon Direct Bonding » par exemple à 1100°C.

Le fait que chaque trou serve aussi de masque mécanique est également un avantage puisqu'il se produit un auto-alignement.

La métallisation « pleine-tranche » permet aussi, lors de la mise en oeuvre de l'invention, une reprise de contact sur le substrat.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1, déjà décrite, est une vue schématique d'une puce sur laquelle est scellé un capot,
- la figure 2, déjà décrite, illustre schématiquement des marches formées à la surface de la puce par des lignes de contact électrique,
- la figure 3, déjà décrite, illustre schématiquement la formation d'évents lorsqu'un capot en verre est scellé sur une puce munie de lignes de contact,
- la figure 4, déjà décrite, illustre schématiquement la formation d'un contact électrique sur une puce, à travers un trou lui-même formé à travers un capot en verre scellé à la puce,
- les figures 5 et 6 illustrent schématiquement un procédé conforme à l'invention, utilisant une couche sacrificielle,
- la figure 7 illustre schématiquement la formation d'un court-circuit lorsque l'épaisseur de la couche sacrificielle est trop faible,
- la figure 8 illustre schématiquement une étape d'un procédé conforme à l'invention,
- les figures 9 et 10 illustrent schématiquement des étapes de modes de mise en oeuvre particuliers du procédé objet de l'invention, et
- les figures 11 à 15 illustrent schématiquement des étapes d'un procédé conforme à l'invention.

### EXPOSÉ DÉTAILLÉ DE MODES DE RÉALISATION PARTICULIERS

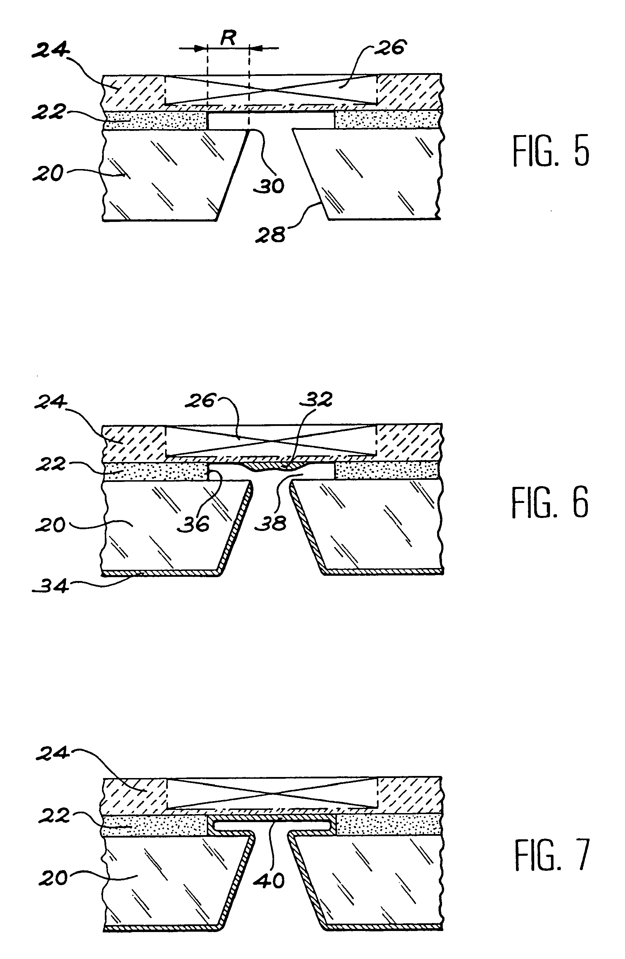

La figure 5 illustre schématiquement un procédé conforme à l'invention.

Sur cette figure 5, on voit en coupe transversale un substrat 20 sur lequel on a formé une couche mince 22 appelée couche sacrificielle.

Sur cette couche sacrificielle, on a formé une première couche 24 dans laquelle on a formé ou on formera ultérieurement, du côté de sa face-avant, une structure 26 que l'on peut appeler élément actif et qui peut être un micro-système électromécanique comme par exemple un accéléromètre, un capteur de pression ou un actionneur.

La couche sacrificielle 22 peut être en SiO₂ par exemple.

On grave un trou 28 à travers le substrat 20, trou qui aboutit à la couche sacrificielle.

Après avoir gravé ce trou on peut alors graver localement la couche sacrificielle, par exemple par une gravure humide au moyen d'acide fluorhydrique pour une couche sacrificielle en SiO₂, de façon que le bord 30 du trou le plus près de la première couche 24 forme un surplomb par rapport à cette première couche 24.

Ce surplomb permet alors, comme l'illustre schématiquement la vue en coupe transversale de la figure 6, de réaliser un dépôt métallique 32 sur la face-arrière de la couche 24 et en regard du trou 28, par exemple par évaporation sous vide ou par pulvérisation cathodique à travers ce trou, sans risquer de créer un court-circuit entre cette couche 24 et le substrat (dans le cas où l'un et l'autre sont conducteurs).

Le dépôt métallique 32 ainsi formé sur la face-arrière de la première couche constitue le contact électrique que l'on voulait réaliser.

Bien entendu une liaison électrique non représentée est formée ou sera formée entre ce contact et la structure 26.

On voit également sur la figure 6 une couche de métal 34 qui s'est également formée sur la face-arrière du substrat ainsi que sur les parois du trou.

Le dépôt de métal à travers le trou 28, sur la face-arrière de la couche 24, est suffisamment directif et ne peut atteindre le fond 36 de la cavité 38 qui s'est formée du fait du recul de la couche sacrificielle lors de la gravure humide de celle-ci.

On considère maintenant un exemple de procédé d'obtention d'une structure conforme à l'invention à partir d'un empilement de couches de type SOI.

La couche dans laquelle on forme la structure ou élément actif est supposée électriquement conductrice.

On utilise par exemple une couche en silicium suffisamment dopé.

Le substrat sur lequel repose cette couche peut être également électriquement conducteur, par exemple en silicium ou en polysilicium.

Ceci impose d'avoir une couche électriquement isolante entre ce substrat et la couche de l'élément actif.

Cette couche isolante peut servir de couche sacrificielle.

Elle peut être en SiO₂.

Lorsque le substrat est électriquement isolant, par exemple en verre, la couche sacrificielle peut être électriquement isolante ou électriquement conductrice.

L'épaisseur de cette couche sacrificielle doit être supérieure à l'épaisseur du dépôt métallique que l'on veut former sur la face-arrière de la couche de l'élément actif.

Sinon il est nécessaire d'élargir le trou avant de faire reculer la couche sacrificielle et créer le surplomb mentionné plus haut par élimination partielle de cette couche sacrificielle.

L'épaisseur de cette couche sacrificielle ne doit pas non plus être trop importante sinon le métal, au moment de son dépôt, irait se déposer également sur les parois de la cavité créée lors de la gravure locale de la couche sacrificielle.

Ceci engendrerait un court-circuit.

On a schématiquement illustré cela sur la figure 7 où l'on voit le substrat 20, la couche sacrificielle 22 formée au-dessus de ce substrat et la couche 24 dans laquelle on a formé ou on formera la structure ou élément actif 26.

On voit également un dépôt métallique 40 qui recouvre non seulement toute la cavité formée dans la couche sacrificielle mais encore les parois du trou et la face-arrière du substrat et provoque ainsi le court-circuit.

L'épaisseur de la couche sacrificielle est avantageusement comprise entre 0,2 µm et 2 µm.

Le recul de la couche sacrificielle dépend de l'épaisseur de cette couche sacrificielle et de la directivité du dépôt métallique.

Il faut un recul de la couche sacrificielle d'autant plus important que l'épaisseur de cette couche sacrificielle est importante et que le dépôt est peu directif.

Pour une couche sacrificielle ayant une épaisseur de 2 µm on peut faire en sorte que le recul R (figure 5) de celle-ci soit de 10 µm.

Il est intéressant que la couche sacrificielle puisse également servir de couche d'arrêt de gravure lors de la gravure profonde de chaque trou dans le substrat.

Cependant cela n'est pas nécessaire.

En ce qui concerne la gravure d'un trou à travers le substrat la forme de ce trou a peu d'importance.

En revanche le recul de la couche sacrificielle est important pour permettre un dépôt de métal sans risquer un court-circuit entre le contact électrique ou plot et le substrat.

Considérons le cas d'un assemblage Si-SiO₂-Si.

Pour former un trou, on peut effectuer une gravure anisotrope du substrat par exemple au moyen de KOH ou de TMAH.

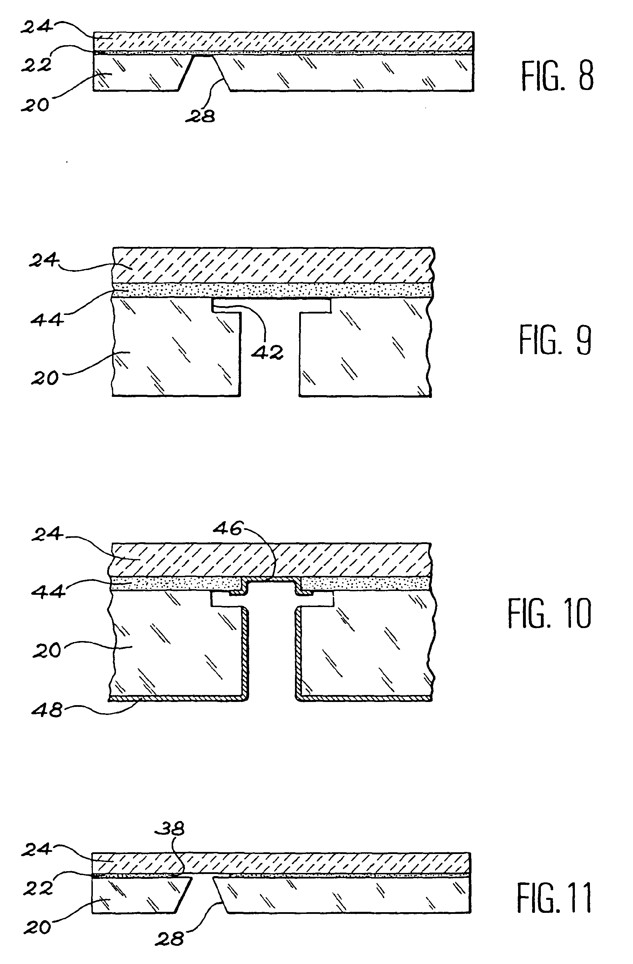

Ceci est schématiquement illustré par la figure 8 où l'on voit, en coupe transversale, le substrat 20 surmonté de la couche sacrificielle 22, elle-même surmontée de la couche 24 destinée à la structure que l'on veut munir d'un contact.

On voit également un trou 28 formé à travers le substrat 20 par gravure chimique anisotrope de celui-ci.

Ce trou peut également être obtenu par gravure anisotrope au moyen d'un plasma.

Il convient de noter que, suivant les conditions de gravure, l'arrêt de gravure, sur une couche isolante, en l'occurrence une couche de SiO₂, peut entraîner une gravure latérale du silicium qui s'étend le long de SiO₂.

Cette gravure latérale fait apparaître une cavité et un surplomb qui peut alors être mis à profit au même titre que ceux qui sont obtenus lors de la gravure de la couche sacrificielle isolante.

Dans ce cas, il n'est pas nécessaire de faire reculer la couche sacrificielle par une gravure humide.

Une gravure sèche peut suffire.

Ceci est schématiquement illustré en coupe transversale par la figure 9 sur laquelle on voit le trou 28 obtenu par la gravure du substrat 20 au moyen d'un plasma et une cavité 42 apparue dans le substrat, du côté de la couche sacrificielle 44 supposée ici isolante, au moment de l'arrêt de gravure sur cette couche sacrificielle.

On voit sur la figure 10 le dépôt métallique 46 que l'on forme sur la face-arrière de la couche 24 et en regard du trou 28 après avoir effectué une gravure sèche de cette couche isolante 44 à travers le trou 28.

On voit encore qu'il n'y a pas de court-circuit entre le substrat et le dépôt 46 destiné à servir de contact à la structure 26.

On voit aussi le dépôt métallique 48 formé sur la face-arrière du substrat et les parois du trou.

En revenant à l'exemple de la figure 8, après la gravure anisotrope du substrat on effectue une gravure chimique de la couche sacrificielle par exemple pendant 5 minutes au moyen d'acide fluorhydrique.

Ceci est schématiquement illustré en coupe transversale sur la figure 11 où l'on voit la cavité 38 formée dans la couche sacrificielle 22.

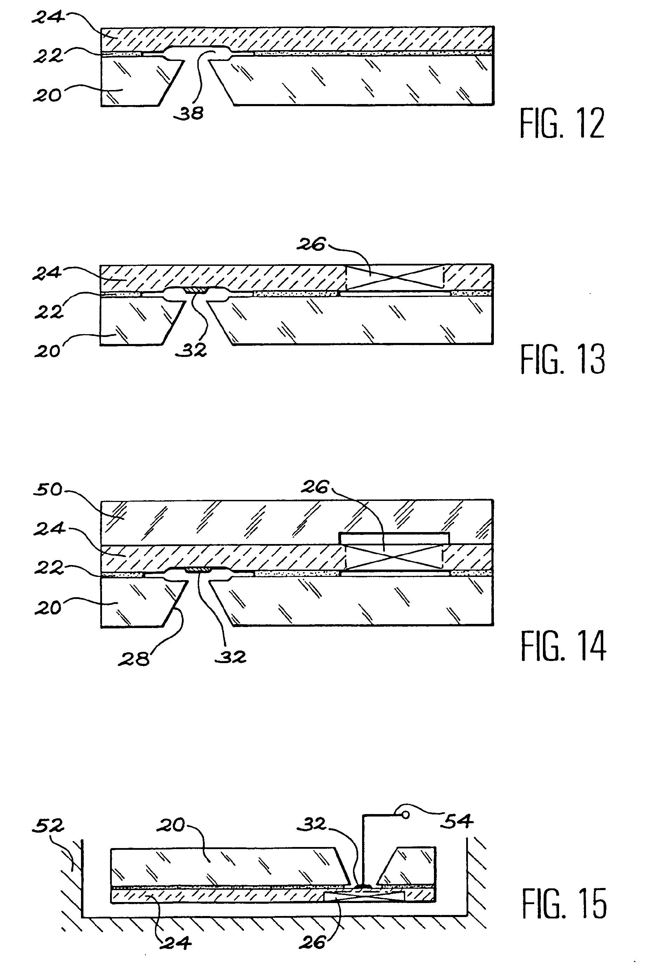

Si l'épaisseur de cette couche sacrificielle est faible vis-à-vis de l'épaisseur du dépôt métallique ultérieurement formé, par exemple dans le cas d'un substrat SIMOX, alors on peut effectuer une gravure anisotrope de la couche sacrificielle par exemple pendant 1 minute au moyen de KOH ou de TMAH puis effectuer à nouveau une gravure chimique de cette couche sacrificielle par exemple pendant 5 minutes au moyen d'acide fluorhydrique pour former la cavité 38 (figure 12).

Ensuite on forme la structure 26 puis on forme un dépôt métallique 32 sur la face-arrière de la couche 24 en regard du trou 28.

Ceci est schématiquement illustré par la figure 13 où l'on voit, en coupe transversale, la structure 26 que l'on a formée ainsi que le dépôt métallique 32.

Si l'on veut recouvrir la structure 26 d'un capot servant de protection contre les poussières ou de blindage électrique ou de moyen de confinement (sous vide ou dans une atmosphère déterminée) on scelle ce capot par exemple au moyen d'un scellement anodique sous vide.

Ceci est schématiquement illustré par la figure 14 où l'on voit en coupe transversale ce capot 50 qui protège la structure 26.

On peut ensuite disposer dans un boîtier 52 (figure 15) la structure 26 formée sur le substrat 20 et munie d'un fil conducteur 54 soudé au contact électrique 32 dont la structure est pourvue.

Au lieu d'être munie d'un seul contact électrique, la structure peut être munie, si cela est nécessaire, de plusieurs contacts électriques que l'on forme respectivement à travers des trous dans le substrat.

Ces trous sont alors formés simultanément dans le substrat de la manière indiquée plus haut et il en est de même pour les trous.

## Revendications

1. Dispositif comprenant:
- un substrat (20);
- une première couche (24) formée sur le substrat;
- un micro-système (26) formé dans la première couche, du coté de la face-avant de celle-ci;
- au moins un trou (28) traversant le substrat, le trou laissant apparaître la face arrière de la première couche, le bord du trou le plus proche de la face-arrière de la première couche surplombant celle-ci pour former une cavité;
- au moins un contact électrique (32) formé sur la face-arrière de la première couche, dans la cavité, en regard du trou,
le trou constituant un passage pour connecter électriquement le micro-système au monde extérieur, la cavité étant surplombée par le bord du trou le plus proche de la première couche, ce surplomb permettant d'isoler électriquement le contact du substrat.

2. Dispositif selon la revendication 1, dans lequel la première couche (24) est électriquement conductrice, le substrat (20) comprend une deuxième couche qui est électriquement isolante et la première couche (24) repose sur cette deuxième couche.

3. Procédé de fabrication du dispositif selon la revendication 1, ce procédé, étant **caractérisé en ce qu'**on forme une première couche (24) sur un substrat (20), on forme le microsystème dans cette première couche, du côté de la face-avant de celle-ci, et au moins un trou (28) à travers le substrat, ce trou laissant apparaître la face-arrière de la première couche, on forme le contact électrique sur cette face-arrière en regard du trou, dans une cavité surplombée par le bord du trou le plus proche de la première couche, ce surplomb permettant d'isoler électriquement le contact du substrat, et le trou constituant un passage pour connecter électriquement le micro-système au monde extérieur.

4. Procédé selon la revendication 3, dans lequel on forme une couche sacrificielle (22, 44) sur le substrat (20) puis la première couche (24) sur scelle couche sacrificielle, on grave cette couche sacrificielle à travers le trou de façon que le bord du trou le plus proche de la première couche forme un sur par rapport à celle-ci et on forme le contact électrique sur la face-arrière de la première couche à travers le trou.

5. Procédé selon la revendication 4, dans lequel le contact électrique (32) est formé par dépôt de métal sur la face-arrière de la première couche (24) à travers le trou.

6. Procédé selon l'une quelconque des revendications 4 et 5, dans lequel la première couche (24) est électriquement conductrice, le substrat (20) comprend une deuxième couche qui est électriquement isolante et l'on forme la couche sacrificielle sur cette deuxième couche puis la première couche sur cette couche sacrificielle.

7. Procédé selon l'une quelconque des revendications 4 et 5, dans lequel la première couche (24) est électriquement conductrice, le substrat (20) comprend une deuxième couche qui est électriquement isolante et l'on forme la première couche sur cette deuxième couche, cette deuxième couche constituant la couche sacrificielle.

8. Procédé selon l'une quelconque des revendications 4 à 7, dans lequel la couche sacrificielle (44) sert de couche d'arrêt lors de la formation de chaque trou.

9. Procédé selon la revendication 3, dans lequel on forme une couche sacrificielle (22, 44) sur le substrat (20) puis la première couche (24) sur cette couche sacrificielle, on forme le trou par une gravure permettant aussi la formation d'une cavité et a d'un surplomb dans le substrat du côté de la face-arrière de la couche sacrificielle, et on grave ensuite la couche sacrificielle jusqu'à la première couche.

10. Procédé selon une quelconque des revendications 3 à 9, dans lequel chaque trou (28) est formé avant de former le microsystème dans la première couche.

11. Procédé selon l'une quelconque des revendications 3 à 10, dans lequel après avoir formé le microsystème (26) première couche (24), on forme, sur la face-avant de la première couche, un capot (50) destiné à confiner le microsystème.

12. Procédé selon l'une quelconque des revendications 3 à 11, dans lequel on forme chaque contact électrique (32) après avoir formé le microsystème dans la première couche.

13. Procédé selon la revendication 11, dans lequel 1 on forme chaque contact électrique (32) après avoir formé le capot.

## Claims

1. A device comprising :
- a substrate (20) ;
- a first layer formed on the substrate ;
- a microsystem (26) formed in the first layer, on its front side ;
- at least one hole (28) which goes through the substrate and reveals the rear side of the first layer, the edge of the hole closest to the rear side of the first layer overhanging the latter to form a cavity ;
- at least one electrical contact (32) formed on the rear side of the first layer, in the cavity, facing the hole ;
the hole constituting a passage to electrically connect the microsystem with the outside world, the cavity being overhung by the edge of the hole closest to the first layer, this overhang allowing for electrical insulation of the contact from the substrate.

2. Device according to claim 1, in which the first layer (24) is electrically conducting, the substrate (20) includes a second layer which is electrically insulating and the first layer (24) rests on this second layer.

3. Process for manufacturing the device according to claim 1, this process being **characterised in that** a first layer (24) is formed on a substrate (20), the microsystem is formed in this first layer on its front side, and at least one hole (28) though the substrate, this hole revealing the rear side of the first layer, with the electrical contact formed on this rear side facing the hole, in a cavity overhung by the edge of the hole closest to the first layer, this edge allowing for electrical insulation of the contact from the substrate, and the hole constituting a passage to electrically connect the microsystem with the outside world.

4. Process according to claim 3, in which a sacrificial layer (22, 44) is formed on the substrate (20) then the first layer (24) on this sacrificial layer, the sacrificial layer is etched through the hole so that the edge of the hole closest to the first layer forms an overhang with respect to the layer and the electrical contact is formed on the rear side of the first layer through the hole.

5. Process according to claim 4, in which the electrical contact (32) is formed by depositing of metal on the rear side of the first layer (24) through the hole.

6. Process according to any of claims 4 and 5, in which the first layer (24) is electrically conducting, the substrate (20) includes a second layer which is electrically insulating and the sacrificial layer is formed on this second layer then the first layer is formed on this sacrificial layer.

7. Process according to any of claims 4 and 5, in which the first layer (24) is electrically conducting, the substrate (20) includes a second layer which is electrically insulating and the first layer is formed on this second layer, this second layer constituting the sacrificial layer.

8. Process according to any of claims 4 to 7, in which the sacrificial layer (44) acts as a blocking layer during formation of each hole.

9. Process according to claim 3, in which a sacrificial layer (22, 44) is formed on the substrate (20) then the first layer (24) is formed on this sacrificial layer, the hole is formed by etching also allowing formation of a cavity and an overhang in the substrate on the rear side of the sacrificial layer, and then the sacrificial layer is etched to the first layer.

10. Process according to any of claims 3 to 9, in which each hole (28) is formed before forming the microsystem in the first layer.

11. Process according to any of claims 3 to 10, in which after having formed the microsystem (26) in the first layer (24), a cap (50) to confine the microsystem is formed on the front side of the first layer.

12. Process according to any of claims 3 to 11, in which each electrical contact (32) is formed after formation of the microsystem in the first layer.

13. Process according to claim 11, in which each electrical contact (32) is formed after formation of the cap.

## Patentansprüche

1. Vorrichtung, umfassend:
- ein Substrat (20);
- eine auf dem Substrat erzeugte erste Schicht (24);
- ein Mikrosystem (26), ausgebildet in der ersten Schicht, auf ihrer Vorderseite;
- wenigstens ein das Substrat durchquerendes Loch (28), wobei durch dieses Loch die Rückseite der ersten Schicht erscheint bzw. zugänglich ist und dabei der Rand des Lochs, der am nahesten bei der Rückseite der ersten Schicht ist, über dieser vorragt, um einen Hohlraum zu bilden;
- wenigstens einen elektrischen Kontakt (32), ausgebildet auf der Rückseite der ersten Schicht, in dem Hohlraum, dem Loch gegenüberstehend,
wobei das Loch einen Durchgang zur elektrischen Verbindung des Mikrosystem mit der Außenwelt bildet und dabei der Rand des Lochs, welcher der ersten Schicht am nahesten ist, über dem Hohlraum vorragt, wobei dieses Vorragen ermöglicht, den Kontakt des Substrats elektrisch zu isolieren.

2. Vorrichtung nach Anspruch 1, bei der die erste Schicht (24) elektrisch leitfähig ist, das Substrat (20) eine zweite Schicht umfasst, die elektrisch isolierend ist und die erste Schicht (24) auf dieser zweiten Schicht ruht.

3. Verfahren zur Herstellung der Vorrichtung nach Anspruch 1, wobei dieses Verfahren **dadurch gekennzeichnet ist, dass** man auf der Vorderseite eines Substrats (20) eine erste Schicht (24) realisiert und wenigstens ein dieses Substrat durchquerendes Loch (28), wobei durch dieses Loch die Rückseite der ersten Schicht erscheint bzw. zugänglich ist, man auf dieser Rückseite, dem Loch gegenüberstehend, den elektrischen Kontakt ausbildet, in einem Hohlraum, über dem der naheste Rand der ersten Schicht vorragt, wobei dieses Vorragen ermöglicht, den Kontakt des Substrats elektrisch zu isolieren, und das Loch einen Durchgang für die elektrische Verbindung des Mikrosystem mit der Außenwelt bildet.

4. Verfahren nach Anspruch 3, bei dem man auf dem Substrat (20) eine Opferschicht (22, 44) und auf dieser Opferschicht die erste Schicht (24) erzeugt, man diese Opferschicht durch das Loch hindurch so ätzt, dass der der ersten Schicht naheste Rand des Lochs über diesem vorragt, und man den elektrischen Kontakt auf der Rückseite der ersten Schicht durch dieses Loch hindurch ausbildet.

5. Verfahren nach Anspruch 4, bei dem der elektrische Kontakt (32) durch das Abscheiden von Metall auf der Rückseite der ersten Schicht (24) ausgebildet wird.

6. Verfahren nach einem der Ansprüche 4 und 5, bei dem die erste Schicht (24) elektrisch leitfähig ist, das Substrat (20) eine zweite Schicht umfasst, die elektrisch isolierend ist, und man die Opferschicht auf dieser zweiten Schicht erzeugt und dann die erste Schicht auf dieser Opferschicht.

7. Verfahren nach einem der Ansprüche 4 und 5, bei dem die erste Schicht (24) elektrisch leitfähig ist, das Substrat (20) eine zweite Schicht umfasst, die elektrisch isolierend ist, und man die erste Schicht auf dieser zweiten Schicht erzeugt und diese zweite Schicht die Opferschicht bildet.

8. Verfahren nach einem der Ansprüche 4 bis 7, bei dem die Opferschicht (44) bei der Bildung jedes Lochs als Stoppschicht dient.

9. Verfahren nach Anspruch 3, bei dem man auf dem Substrat (20) eine Opferschicht (22, 24) und dann auf dieser Opferschicht die erste Schicht (24) erzeugt, man das Loch durch eine Ätzung ausbildet, die auch die Ausbildung eines Hohlraums und eines Überhangs in dem Substrat auf der Seite der Opferschicht-Rückseite ermöglicht, und man anschließend die Opferschicht bis zur ersten Schicht abätzt.

10. Verfahren nach einem der Ansprüche 3 bis 9, bei dem jedes Loch (28) ausgebildet wird, bevor das Mikrosystem in der ersten Schicht ausgebildet wird.

11. Verfahren nach einem der Ansprüche 3 bis 10, bei dem man, nachdem das Mikrosystem (26) in der ersten Schicht (24) ausgebildet worden ist, auf der Vorderseite der ersten Schicht eine Abdeckung (50) ausbildet, die dazu bestimmt ist, das Mikrosystem einzuschließen.

12. Verfahren nach einem der Ansprüche 3 bis 11, bei dem man jeden elektrischen Kontakt (32) ausbildet, nachdem man das Mikrosystem in der ersten Schicht ausgebildet hat.

13. Verfahren nach Anspruch 11, bei dem man jeden elektrischen Kontakt (32) ausbildet, nachdem man die Abdeckung ausgebildet hat.
